# EUROPEAN PATENT APPLICATION

(11) **EP 1 422 281 A1**
(43) Date of publication of application: **26.05.2004**
(21) Application number: 02405997.4
(22) Date of filing: 19.11.2002
(51) Int. Cl.: C09K 11/06, H05B 33/14, H01L 51/20

(54) **Organic electroluminescent element**

(71) Applicant: Ciba Specialty Chemicals Holding Inc., 4057 Basel (CH)
(72) Inventor: Chisholm Greig, Glasgow G776XW (GB); Wilson,Sharon Kathleen, 1019 XG amsterdam (NL)

(57) **Abstract**

Organic electroluminescent elements comprising disazo (yellow diarylide) pigments as light emitting material, and the use of these elements in electroluminescent devices (displays) are provided. The pigments exhibit solid state fluorescence which prohibits self-quenching of light emission when incorporated into said devices. The devices show high stability and good brightness in light emission, and are of low cost to manufacture.

## Description

The present invention relates to an organic electroluminescent element to be used for various display devices.
Electroluminescent elements (hereinafter referred to a EL-elements) have been used for high quality word processors as displaying devices offering high quality pictures.
Conventionally, EL-elements are prepared by forming a light emitting layer containing inorganic materials, such as ZnS:Mn, on a glass substrate provided with a transparrent electrode, such as ITO (Indium Tin Oxide), by means of the sputtering method or by coating a mixture prepared by dispersing the light emitting material in a polymer matrix, followed by forming a counter electrode on said light emitting layer.

Disadvantages of inorganic EL-elements are e.g. that the number of materials composed of suitable inorganic elements is comparatively limited when compared to the effectively unlimited number of organic compounds which may be synthesized. This allows for greater fine-tuning of the properties. They are expensive to manufacture when compared with organic molecules. The complexity of manufacture of inorganic based devices is higher than that for organic based devices. They require a higher operating voltage than organic devices making them less practical for portable applications where battery lifetime is a consideration. They are of comparatively low brightness (luminosity).

Accordingly, in order to solve these problems, organic EL-elements have been developed as an alternative to inorganic EL-elements because they can be driven by applying a low DC (direct current) voltage, because there is practically an indefinitely large possibility for selecting a light emitting material since it is an organic material, so that it is possible to emit light of any desired color, and furthermore, because it is relatively easy and cheap to produce such organic EL-elements.

The working principle of the organic EL-elements is based on the phenomenon that electrons and positive holes, injected from a negative electrode and a positive electrode, respectively, recombine in the organic light emitting layer, thereby generating excitons, which are excited states thereof. The thus generated excitons diffuse in said light emitting layer, which then emits light when it returns to the ground state. Therefore, the wavelength of emitted light is only dependent on the difference in energy between the ground state and and the excited states.

In practice, organic EL-elements are usually produced by forming a positive elctrode, a positive hole transporting layer, a light emitting layer and a negative electrode in this order, thereby decreasing the treshold voltage for light emission. The electrodes are usually formed by the vacuum deposition method or sputtering method, and the positive hole transporting layer and the organic light emitting layer are formed by vacuum deposition. If necessary, an electron transporting layer is placed between the light emitting layer and the negative electrode. Whichever the case may be, light emission of about 1'000 cd/m² (cd = candle (candela), unit of luminous intensity) in intensity has been obtained upon application of a voltage of as low as 10 Volt (V) or less.

Inspite of the above mentioned advantageous possibilities, there are various conditions to be observed when selecting an organic light emitting material useful in EL-elements.

The light emitting materials must at least satisfy the following conditions:
(a) Showing of strong fluorescence, advantageously in the solid state.
(b) Forming of an amorphous layer (film) by vacuum deposition, which is a prerequisite for forming an even and pinholeless layer (pinholes can cause short circuit and electrical breakdown).
(c) Not forming an exiplex with the hole transporting layer (the excited state can be quenched by said interaction and no EL emission is observed).
(d) Showing high stability to oxygen, moisture and the like (long life time).
Furthermore , it is always an advantage if the material is of low cost to manufacture.

It is now an object of the present invention to provide organic EL-elements which show good brightness in light emission, and which can be easily manufactured at low cost.

It has been found that this object can be achieved by using an organic pigment of formula (I) (disclosed hereinafter) as light emitting material, which pigment being stable against oxygen and moisture, showing strong fluorescence in the solid state, forming a pinholeless smooth layer even in the case of vacuum depostion, and forming no exiplex with any positive hole transporting material.

Therefore in a first aspect, the present invention relates to an organic EL-element which comprises as light emitting material a pigment of the general formula (I) 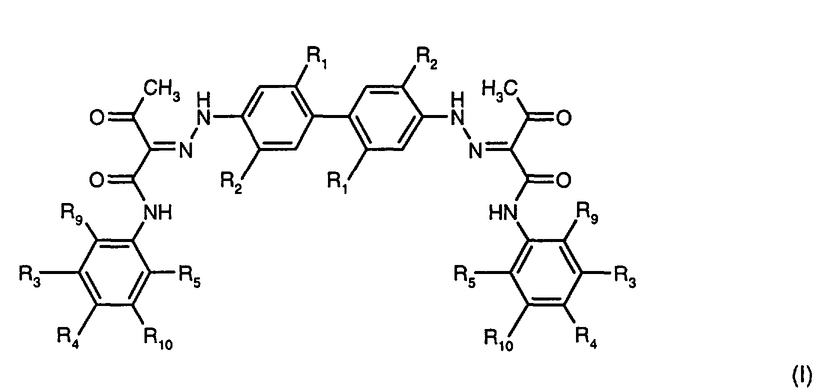 and tautomers thereof,
wherein R₁ and R₂ are each independently hydrogen, chloro or methoxy,
R₃ is hydrogen, C₁₋₂₀-alkyl, C₁₋₂₀-alkoxy, C₂₋₂₀ alkenyl, C₁₋₂₀ alkylthio, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which each R⁷ and R⁸ are each independently hydrogen, C₁₋₄-alkyl or phenyl,
R₄ is hydrogen, C₁₋₂₀-alkyl, C₁₋₂₀-alkoxy, C₂₋₂₀ alkenyl, C₁₋₂₀ alkylthio, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which R⁷ and R⁸ are each independently hydrogen, C₁₋₄-alkyl or phenyl,
R₅ is hydrogen, C₁₋₂₀-alkyl, C₁₋₂₀-alkoxy, C₂₋₂₀ alkenyl, C₁₋₂₀ alkylthiol, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which R⁷ and R⁸ are each independently hydrogen, C₁₋₄-alkyl or phenyl, and R₉ and R₁₀ have each independently the meanings of R₃, R₄ and R₅.

The alkyl groups, the alkenyl groups and the alkyl residue of the alkoxy, the alkylthio and the dialkylamino groups may be straight chain branched, straight chain groups being preferred. Examples of suitable alkyl groups are methyl, ethyl. propyl, isopropyl, n-, sec- and tert-butyl, further pentyl, hexyl, heptyl, octyl, decyl, dodecyl or octadecyl.
Halogen is fluoro, chloro, bromo or iodo, preferably chloro.

Preferred are those comounds of formula (I) wherein R₁ and R₂ have the meanings indicated and R₃ to R₅ and R₉ and R₁₀ each independently are hydrogen, C₁₋₄-alkyl, C₁₋₄-alkoxy or chloro, especially preferred hydrogen, methyl, methoxy or chloro.

The compounds of the general formula (I) are known disazo (diarylide yellow and orange) pigments which are disclosed and described in e.g. Industrial *Organic Pigments, W. Herbst, K. Hunger, 2*^{*nd*} *edition, VCH Verlagsgesellschaft, Weinheim, 1997* or in *The Colour Index, issued by the Society of Dyers and Colorists and The American Association of Textile Chemists and Colorists*.

The organic EL-elements of the present invention usually employs an organic thin film as a light emitting layer, so that it is necessary to use a substrate of sufficient mechanical strength. Details of the substrate follow hereinafter.

In a further aspect, the present invention relates to the use of the disazo (diarylide yellow) pigments of the general formula (I) for the preparation of organic EL-elements and the use of said EL-elements in EL-devices, such as e.g. luminescent displays. Such EL-devices are well-known in the art (e.g. described in Appl. Phys. Lett. 51, 913 (1987)).

In a preferred embodiment EL devices are used which have the following compositions:
(i) an anode(positive electrode)/a hole transporting layer/an electron transporting layer/a cathode (negative elctrode)
   in which the compounds of general formula (I) are used either as positive-hole transport compounds, which can be exploited to form the light emitting and hole transporting layers, or as electron transport compounds, which can be exploited to form the light-emitting and electron transporting layers,
   and
(ii) an anode/a hole transporting layer/a light-emitting layer/an electron transporting layer/a cathode,
   in which the compounds of general formula (I) form the light-emitting layer regardless of whether they exhibit positive-hole or electron transport properties in this constitution.
It is possible that the light emitting layer can consist of two or more fluorescent compounds of general formula (I) for energy donor(s) and energy acceptor(s).

The devices can be prepared in several well-known ways. Generally, vacuum evaporation is extensively used for the preparation. Preferably, the organic layers are laminated in the above order on a commercially available indium-tin-oxide ("ITO") glass substrate held at room temperature, which works as the anode in the constitutions. The layer (film) thickness is preferably in the range of 1 to 10⁴ nm; further preferred are the ranges 1 to 5000 nm, 1 to 10³ nm, and finally 1 to 500 nm. The cathode metal such as Mg/Ag alloy and Li-AI binary system of ca. 200 nm is laminated on the top of the organic layers. The vacuum during the deposition is preferably less than 0.1333 Pa (1x10⁻³ Torr), more preferably less than 1.333x 10⁻³ Pa (1x10⁻⁵ Torr), and mostly preferred less than 1.333x 10⁻⁴ Pa (1x10⁻⁶ Torr).

As anode usual anode materials which possess high work function such as metals like gold, silver, copper, aluminum, indium, iron, zinc, tin, chromium, titanium, vanadium, cobalt, nickel, lead, manganese, tungsten and the like, metallic alloys such as magnesium/copper, magnesium/silver, magnesium/aluminum, aluminum/indium and the like, semiconductors such as Si, Ge, GaAs and the like, metallic oxides such as indium-tin-oxide ("ITO"), ZnO and the like, metallic compounds and the like, and furthermore, electroconducting polymers such as polyacetylene, polyaniline, polythiophene, polypyrrole, polyparaphenylene and the like, preferably ITO, most preferably ITO on glass as substrate can be used.

Of these electrode materials, metals, metallic alloys, metallic oxides and metallic compounds can be transformed into electrodes, for example, by means of the sputtering method. In the case of using a metal or a metallic alloy as a material for an electrode, the electrode can be formed also by the vacuum deposition method. In the case of using a metal or a metallic alloy as a material forming an electrode, the electrode can be formed, furthermore, by the chemical plating method (see for example, Handbook of Electrochemistry, pp 383-387, Mazuren, 1985).
In the case of using an electroconducting polymer, an electrode can be made by forming it into a film by means of anodic oxidation polymerization method onto a substrate which is previously provided with an electroconducting coating. The thickness of an electrode to be formed on a substrate is not limited to a particular value, but, when the substrate is used as a light emitting plane, the thickness of the electrode is preferably within the range of from 1 nm to 100 nm, more preferably, within the range of from 5 to 50 nm so as to ensure transparency.

In a preferred embodiment ITO is used on a substrate having an ITO film thickness in the range of from 10 nm (100 Å) to 1 µ (10000 Å), preferably from 20 nm (200 Å) to 500 nm (5000 Å). Generally, the sheet resistance of the ITO film is chosen in the range of not more than 100 Ω/cm², preferred from not more than 50 Ω/cm².
Such anodes are commercially available e.g. from e.g. Japanese manufacturers such as Geomatech Co.Ltd., Sanyo Vacuum Co. Ltd., Nippon Sheet Glass Co. Ltd.

As substrate of the light emitting layer either an electroconducting or electrically insulating material can be used. In case of using an electroconducting substrate, a light emitting layer or a positive hole transporting layer is directly formed thereupon, while in case of using an electrically insulating substrate, an electrode is firstly formed thereupon and then a light emitting layer or a positive hole transporting layer is superposed.

The substrate may be either transparent, semi-transparent or opaque. However, in case of using a substrate as an indicating plane, the substrate must be transparent or semi-transparent.

Transparent electrically insulating substrates are, for example, inorganic compounds such as glass, quartz and the like, organic polymeric compounds such as polyethylene, polypropylene, polymethylmethacrylate, polyacrylonitrile, polyester, polycarbonate, polyvinylchloride, polyvinylalcohol, polyvinylacetate and the like. Each of these substrates can be transformed into a transparent electroconducting substrate by providing it with an electrode according to one of the methods described above.

As examples of semi-transparent electrically insulating substrates, there are inorganic compounds such as alumina, YSZ (yttrium stabilized zirconia) and the like, organic polymeric compounds such as polyethylene, polypropylene, polystyrene, epoxy resin and the like. Each of these substrates can be transformed into a semi-transparent electroconducting substrate by providing it with an electrode according to one of the abovementioned methods.

As examples of opaque electroconducting substrates, there are metals such as aluminum, indium, iron, nickel, zinc, tin, chromium, titanium, copper, silver, gold, platinum and the like, various elctroplated metals, metallic alloys such as bronze, stainless steel and the like, semiconductors such as Si, Ge, GaAs, and the like, electroconducting polymers such as polyaniline, polythiophene, polypyrrole, polyacetylene, polyparaphenylene and the like.

A substrate can be obtained by forming one of the above listed substrate materials to a desired dimension. It is preferred that the substrate has a smooth surface. Even if it has a rough surface, however, it will not cause any problem for practical use, provided that it has round unevenness having a curvature of not less than 20 µm. As for the thickness of the substrate, there is no restriction as far as it ensures sufficient mechanical strength.

As cathode usual cathode materials which possess low work function such as alkali metals, earth alkaline metals, group III elements, silver, and copper as well as alloys or mixtures thereof such as sodium, lithium, potassium, sodium-potassium alloy, magnesium, magnesium-silver alloy, magnesium-copper alloy, magnesium-aluminum alloy, magnesium-indium alloy, aluminum, aluminum-aluminum oxide alloy, aluminum-lithium alloy, indium, calcium, and materials exemplified in EP-A 499,011 such as electroconducting polymers e.g. polypyrrole, polythiophene, polyaniline, polyacetylene etc., preferably Mg/Ag alloys, or Li-Al compositions can be used.

In a preferred embodiment magnesium-silver alloy or a mixture of magnesium and silver mixture, or lithium-aluminum alloy or a mixture of lithium and aluminum can be used in a film thickness in the range of from 10 nm (100 Å) to 1 µm (10000 Å), preferably from 20 nm (200 Å) to 500 nm (5000 Å).

Such cathodes can be deposited on the foregoing electron transporting layer by known vacuum deposition techniques described above.

In a preferred ambodiment of this invention a light-emitting layer can be used between the hole transporting layer and the electron transporting layer.

As methods for forming said thin film, there are, for example, the vacuum deposition method, the spin-coating method, the casting method, the Langmuir-Blodgett ("LB") method and the like. Among these methods, the vacuum deposition method, the spin-coating method and the casting method are particularly preferred in view of ease in operation and cost. In case of forming a thin film using a fluorescent pigment of general formula (I) by means of the vacuum deposition method, the conditions under which the vacuum deposition is carried out are usually strongly dependent on the properties, shape and crystalline state of the compound. However, optimum conditions can be selected for example within the range of from 100 to 400°C in temperature for the heating boat, -100 to 350°C in substrate temperature, 1.33x10⁴ Pa (1x10² Torr) to 1.33x10⁻⁴ Pa (1x10⁻⁶ Torr) in pressure and 1 pm to 6 nm/sec in deposition rate.

In an organic EL element, the thickness of the light emitting layer thereof is one of the factors determining its light emission properties. For example, if a light emitting layer is not sufficiently thick, a short circuit can occur quite easily between two electrodes sandwiching said light emitting layer, and therefor, no EL emission is obtained. On the other hand, if the light emitting layer is excessively thick, a large potential drop occurs inside the light emitting layer because of its high electrical resistance, so that the threshold voltage for EL emission increases. Accordingly, it is necessary to limit the thickness of an organic light emitting layer within the range of from 5 nm to 5 µm. A preferable thickness is within the range of from 10 nm to 500 nm.

In the case of forming a light emitting layer by using the spin-coating method and the casting method, the coating can be carried out using a solution prepared by dissolving the fluorescent pigment of general formula (I) in a concentration of from 0.0001 to 90% by weight in an appropriate organic solvent such as benzene, toluene, xylene, tetrahydrofuran, N,N-dimethylformamide, dichloromethane, dimethylsulfoxide and the like. Herein, the higher the concentration of fluorescent pigment of formula (I), the thicker the resulting film, while the lower the concentration, the thinner the resulting film. However, if the concentration exceeds 90% by weight, the solution usually is so viscous that it no longer permits forming a smooth and homogenous film. On the other hand, as a rule, if the concentration is less than 0.0001 % by weight, the efficiency of forming a film is too low to be economical. Accordingly, a preferred concentration of the fluorescent pigment of general formula (I) is within the range of from 0.01 to 80% by weight.

In the case of using the above spin-coating or casting method, it is possible to further improve the homogeneity and mechanical strength of the resulting layer by adding a polymer binder in the solution for forming the light emitting layer. In principle, any polymer binder may be used, provided that it is soluble in a solvent in which the fluorescent pigment of general formula (I) is dissolved. Examples of such polymer binders are polycarbonate, polyvinylalcohol, polymethacrylate, polymethylmethacrylate, polyester, polyvinylacetate, epoxy resin and the like. A solution for forming a light emitting layer may have any concentrations of the fluorescent compound I, of a polymer binder and solvent. However, if the solid content composed of the polymer binder and fluorescent pigment of formula (I) exceeds 99% by weight, the fluidity of the solution is usually so low that it is impossible to form a light emitting layer excellent in homogeneity. On the other hand, if the content of fluorescent pigment of formula (I) is substantially smaller than that of the polymer binder, in general the electrical resistance of said layer is very large, so that it does not emit light unless a high voltage is applied thereto.
Furthermore, since the concentration of fluorescent pigment of formula (I) in the layer is small in this case, its light emission efficiency is relatively low. Accordingly, the preferred composition ratio of a polymer binder to fluorescent pigment of formula (I) is chosen within the range of from 10:1 to 1:50 by weight, and the solid content composed of both components in the solution is preferably within the range of from 0.01 to 80% by weight, and more preferably, within the range of about 0.1 to 60% by weight.

In the case of forming a light emitting layer by the spin-coating method or casting method, the thickness of said layer may be selected in the same manner as in the case of forming a light emitting layer by the vacuum deposition method. That is, the thickness of the layer preferably is chosen within the range of from 5 nm to 5 µm, and more preferably, within the range of from 10 nm to 500 nm.

As hole-transporting materials known organic compounds, such as polyvinyl carbazole, 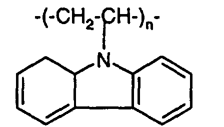 a triphenylamine derivative ("TPD") compound disclosed in J.Amer.Chem.Soc. 90 (1968) 3925 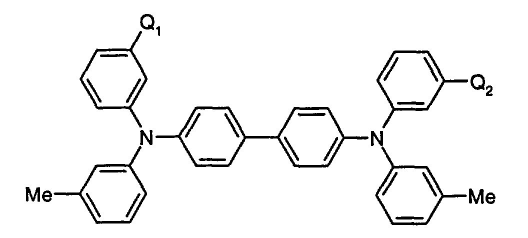 wherein Q₁ and Q₂ each represent a hydrogen atom or a methyl group;
a compound disclosed in J. Appl. Phys. 65(9) (1989) 3610 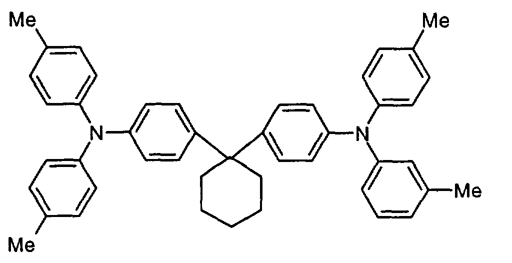 a stilbene based compound 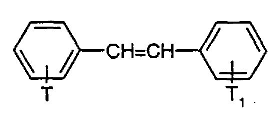 wherein T and T₁ stand for an organic residue;
a hydrazone based compound 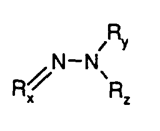 and the like can be used.

Compounds to be used as a positive hole transporting material are not restricted to the above listed compounds. Any compound having a property of transporting positive holes can be used as a positive hole transporting material such as triazole derivatives, oxadiazole derivatives, imidazole derivatives, polyarylalkane derivatives, pyrazoline derivative, pyrazolone derivatives, phenylene diamine derivatives, arylamine derivatives, amino substituted chalcone derivatives, oxazole derivatives, stilbenylanthracene derivatives, fluorenone derivatives, hydrazone derivatives, stilbene derivatives, copolymers of aniline derivatives, electro-conductive oligomers, particularly thiophene oligomers, porphyrin compounds, aromatic tertiary amine compounds, stilbenyl amine compounds etc. Particularly, aromatic tertiary amine compounds such as N,N,N',N'-tetraphenyl-4,4'-diaminobiphenyl, N,N'-diphenyl-N,N'-bis(3-methylphenyl)- 4,4'-diaminobiphenyl (TPD), 2,2'-bis(di-p-torylaminophenyl)propane, 1,1'-bis(4-di-torylaminophenyl)-4-phenylcyclohexane, bis(4-dimethylamino-2-methylphenyl)phenylmethane, bis(4-di-p-tolylaminophenyl)phenyl-methane, N,N'-diphenyl-N,N'-di(4-methoxyphenyl)-4,4'-diaminobiphenyl, N,N,N',N'-tetraphenyl-4,4'-diaminodiphenylether, 4,4'-bis(diphenylamino)quaterphenyl, N,N,N-tri(p-tolyl)amine, 4-(di-p-tolylamino)-4'-[4-(di-p-tolylamino)stilyl]stilbene, 4-N,N-diphenylamino-(2-diphenylvinyl)benzene, 3-methoxy-4'-N,N-diphenylaminostilbene, N-phenylcarbazole etc.

Furthermore, 4,4'-bis[N-(1-naphtyl)-N-phenylamino]biphenyl disclosed in US 5,061,569, the compounds in which three triphenylamine units are bound to a nitrogen atom like "star-burst" structure e.g. 4,4',4"-tris[N-(3-methylphenyl)-N-phenylamino]triphenylamine disclosed in EP-A 508,562.

A positive hole transporting layer can be formed by preparing an organic film containing at least one positive hole transporting material on the anode. The positive hole transporting layer can be formed by the vacuum deposition method, the spin-coating method, the casting method, the LB method and the like. Of these methods, the vacuum deposition method, the spin-coating method and the casting method are particularly preferred in view of ease and cost.

In the case of using the vacuum deposition method, the conditions for deposition may be chosen in the same manner as described for the formation of a light emitting layer (see above). If it is desired to form a positive hole transporting layer comprising more than one positive hole transporting material, the coevaporation method can be employed using the desired compounds.

In the case of forming a positive hole transporting layer by the spin-coating method or the casting method, the layer can be formed under the conditions described for the formation of the light emitting layer (see above).

As in the case of forming a light emitting layer using a solution containing a polymer binder, a smoother and more homogeneous positive hole transporting layer can be formed by using a solution containing a binder and at least one positive hole transporting material. The coating using such a solution can be performed in the same manner as in cases of forming a light emitting layer using a polymer binder. Any polymer binder may be used, provided that it is soluble in a solvent in which at least one positive hole transporting material is dissolved. Examples of appropriate polymer binders and of appropriate and preferred concentrations are given above when describing the formation of a light emitting layer. The thickness of a positive hole transporting layer is preferably chosen in the range of from 0.5 to 1000 nm, preferably from 1 to 100 nm, more preferably from 2 to 50 nm.

As electron transporting materials for an electron-transporting layer it is preferred to have a high electron injection efficiency from the cathode and a high electron mobility. The following materials can be exemplified for electron transporting materials: tris(8-hydroxyquinolinoato)-aluminum(III) and its derivatives, bis(10-hydroxybenzo[h]quinolinolato)beryllium(II) and its derivatives, oxadiazole derivatives such as 2-(4-biphenyl)-5-(4-tert.-butylphenyl)-1,3,4-oxadiazole and its dimer systems such as 1,3-bis(4-tert.-butylphenyl-1,3,4)oxadiazolyl)-biphenylene and 1,3-bis(4-tert.-butylphenyl-1,3,4-oxadiazolyl)phenylene, triazole derivatives, phenanthroline derivatives or perylene tetracarboxylic acid derivatives such as disclosed in Appl. Phys. Lett. 48 (2), 183 (1986).

An electron transporting layer can be formed by preparing an organic film containing at least one electron transporting material on the hole transporting layer or on the light-emitting layer. The electron transporting layer can be formed by the vacuum deposition method, the spin-coating method, the casting method, the LB method and the like.

Additionally, if the emissive layer and the electron layers are one and the same, i.e. there is no separate emissive layer, then the electron transport layer can be doped with a small quantity of a fluorescent material. Such a design allows the formulating of range of colours based on only one host material. Suitable fluorescent materials may be the pigments described herein. Optionally, the pigments can be combined with other dyes or pigments.

As in the case of forming a light emitting layer or a positive hole transporting layer by using a solution containing a polymer binder, a smoother and more homogeneous electron transporting layer can be formed by using a solution containing a binder and at least one electron transporting material.

The thickness of an electron transporting layer is preferably chosen in the range of from 0.5 nm to 1000 nm, preferably from 1 nm to 100 nm, more preferably from 2 to 50 nm.

The inventively used pigments can be synthesized in a straightforward manner from readily available starting materials by standard azo/coupling procedures well known in the art. They are fluorescent in the solid state which is an important feature for the manufacture of EL-elements and EL-devices, respectively. This solid state fluorescence prohibits self-quenching of the emission when incorprated into said element/device. It could not be expected that the pigments of general formula (I) would show EL-properties and further excellent behaviour when incorporated in EL-devices, such as stability and brightness in light emission.

Applications utilizing the decribed organic LE-devices comprise e.g. flat panel displays, such as computer monitors, screens for mobile phones and PDAs, advertising displays, and further any kind of application where a bright display is required.

The low cost of these materials would be particular advantageous for cheap disposible items such as single-use cameras or calculators, or a similar device where a digital display is required.

The following examples further illustrate the various aspects of the present invention and are not intended to limit the scope of thereof. In the examples all parts and percentages are by weight unless otherwise indicated.

### Examples

All fluorescence spectra are recorded on a Hitachi F-4500 fluorescence spectrometer equipped with a 150 W xenon lamp and a Hamamatsu Photonics R928 photomultiplier. The excitation wavelength is set at the absorption maximum for the sample in the solution state. Thin film fluorescence spectra are recorded by vacuum deposition of the sample onto a glass plate. The electroluminescent device structure is as follows:
indium tin oxide anode / diamine hole transporting layer / sample / Li Ag cathode (cf. Appl. Phys. Letter 51, 913 (1987))

Example 1: o-Dianisidine-dihydrochloride (25 g) is stirred in water (65 ml) to form a paste. Concentrated hydrochloric acid (21.5 g) is added and the mixture stirred for a further five minutes. The temperature is lowered to 0 °C by addition of ice. The bulk of a solution of sodium nitrite (11.1 g) in water (50 ml) is added over 20 minutes. The temperature is allowed to rise to 15-20 °C. A fine tetrazotisation end point is then reached by addition of the remaining nitrite solution over a further 10 minutes. Ethylenediaminetetraacetic acid (0.1 g) and celite (0.1 g) are then added and the mixture is left to stir for a further 30 minutes. The tetrazo solution is then filtered and washed with water (60 ml).

In a separate vessel (the coupling vessel) a mixture of acetoacetanilide (30.1 g) and 47 % aqueous sodium hydroxide solution (14.5 g) are stirred in water (180 ml) to give a solution. A solution of sodium formate (15.8 g ) in water (180 ml) is added. Glacial acetic acid (14.4 g) in water (25 ml) is added over 5 minutes to pH 6.

The acetoacetanilide vessel is then heated to 35 to 40°C by steam injection and the tetrazotised amine is added over 75 minutes to give an orange slurry. The slurry is then left to stir for 90 minutes at 30-32 °C prior to being heated to 90 °C. The orange slurry is held at this temperature for 1 hour, before being cooled to 70°C, filtered, washed, and dried overnight at 70°C. The resulting dried pigment is sieved through a 250 µm screen to give a powdered pigment composition. Table 1 below shows the spectral properties.

Example 2: o-Dianisidine dihydrochloride (18.8 g) is stirred in water (130. ml) to form a paste. Concentrated hydrochloric acid (16.0 g) is added and the mixture stirred for a further five minutes. The temperature is lowered to 0 °C by addition of ice. The bulk of a solution of sodium nitrite (8.3 g) in water (50 ml) is added over 20 minutes. The temperature is allowed to rise to 15-20 °C. A fine tetrazotisation end point is then reached by addition of the remaining nitrite solution over a further 10 minutes. Ethylenediaminetetraacetic acid (0.1 g) and celite (0.1 g) are then added and the mixture is left to stir for a further 30 minutes. The tetrazo solution is then filtered and washed with water (60 ml).
In a separate vessel (the coupling vessel) a mixture of acetoacet-4'-chloro-2',5'-dimethoxyanilide (34.7 g) and 47 % aqueous sodium hydroxide solution (10.9 g) are stirred in water (180 ml) to give a solution. A solution of sodium formate (11.2 g) in water (270 ml) is added. Glacial acetic acid (10.9 g) in water (25 ml) is added over 5 minutes to pH 6.

The anilide vessel is then heated to 35-40 °C by steam injection and the tetrazotised amine is added over 75 minutes to give an orange slurry. The slurry is then left to stir for 90 minutes at 30-32 °C prior to being heated to 90 °C. The orange slurry is held at this temperature for 1 hour, before being cooled to 70 °C, filtered, washed, and dried overnight at 70 °C. The resulting dried pigment is sieved through a 250 µm screen to give a powdered pigment composition. The Table below summarizes the spectral properties.

Example 3: Identical to example 1 except that acetoacet-*m*-xylidide (35.0 g) is added in place of the acetoacetanilide. The Table below summarizes the spectral properties.

Example 4: Identical to example 1 except that acetoacet-*o*-anisidide (35.2 g) is added in place of the acetoacetanilide. The Table below summarizes the spectral properties.

**Table:**

| **Spectral properties** | | | | | |
|---|---|---|---|---|---|
| Example | Solution | Thin Film | Powder | Electroluminescence | |
| | λ_{fl} (nm) | λ_{fl} (nm) | λ_{fl} (nm) | λ_{fl} (nm) | Lₘₐₓ (cdm⁻²) |
| 1 | 573 | 563 | 586, 602(w) | 568 | 3 |
| 2 | 575 | 563 | 595 | 558 | 3 |
| 3 | 551 | 561 | 578 | 563 | 60 |
| 4 | 550 | 556 | 584 | 563 | 150 |

## Claims

1. An organic electroluminescent element comprising as light emitting material a pigment of the general formula (I) 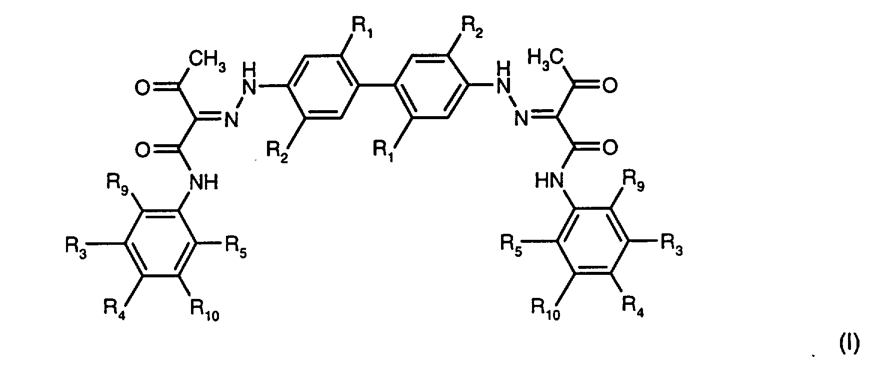 and tautomers thereof,
wherein R₁ and R₂ are each independently hydrogen, chloro or methoxy,
R₃ is hydrogen, C₁₋₂₀-alkyl, C₁₋₂₀-alkoxy, C₂₋₂₀ alkenyl, C₁₋₂₀ alkylthio, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which each R⁷ and R⁸ are each independently hydrogen, C₁₋₄-alkyl or phenyl,
R₄ is hydrogen, C₁₋₂₀-alkyl, C₁₋₂₀-alkoxy, C₂₋₂₀ alkenyl, C₁₋₂₀ alkylthio, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which R⁷ and R⁸ are each independently hydrogen, C₁₋₄-alkyl or phenyl,
R₅ is hydrogen, C₁₋₂₀-alkyl, C₁₋₂₀-alkoxy, C₂₋₂₀ alkenyl, C₁₋₂₀ alkylthiol, C₁₋₂₀-alkoxycarbonyl, hydroxyC₁₋₄-alkoxy, phenyl, benzyl, phenylthio, halogen, -CN, -NO₂, -CF₃, -COR⁷, -COOR⁷, -CONR⁷R⁸, -SO₂R⁷, -SO₂NR⁷R⁸, -NR⁷NR⁸ or -OR₂ in which R⁷ and R⁸ are each independently hydrogen, C₁₋₄-alkyl or phenyl, and R₉ and R₁₀ have each independently the meanings of R₃, R₄ and R₅.

2. The organic electroluminescent element according to claim 1, wherein R₁ and R₂ each independently are hydrogen, chloro or methoxy, and R₃ to R₅ and R₉ and R₁₀ each independently are hydrogen, C₁₋₄-alkyl, C₁₋₄-alkoxy or chloro, preferably hydrogen, methyl, methoxy or chloro.

3. The organic electroluminescent element according to any of claims 1 and 2 in form of an organic thin film which comprises a substrate of sufficent mechanical strength.

4. An electroluminescent device comprising an organic electroluminescent element according to any of claims 1 to 3.

5. The electroluminescent device according to claim 4 comprising in this order
an anode(positive electrode)/a hole-transporting layer/an electron transporting layer/and a cathode (negative elctrode),
in which the compounds of general formula (I) are used either as positive hole transport compounds, which can be exploited to form the light-emitting and hole-transporting layers, or as electron transport compounds, which can be exploited to form the light-emitting and electron transporting layers.

6. The electroluminescent device according to claim 4 comprising in this order
an anode/a hole-transporting layer/a light-emitting layer/an electron transporting layer/and a cathode,
in which the compounds of general formula (I) form the light-emitting layer regardless of whether they exhibit positive-hole or electron transport properties in this constitution.

7. The electroluminescent device according to one of claims 4 to 6 comprising luminescent displays.
